Europäisches Patentamt

European Patent Office

Office européen des brevets

(11) Veröffentlichungsnummer: **0 399 286**
**A1**

## (12) EUROPÄISCHE PATENTANMELDUNG

(21) Anmeldenummer: 90108664.5

(22) Anmeldetag: 08.05.90

(51) Int. Cl.5: **H01L 21/331, H01L 21/268,**
**H01L 21/223, H01L 21/82**

(30) Priorität: 23.05.89 DE 3916773

(43) Veröffentlichungstag der Anmeldung:
28.11.90 Patentblatt 90/48

(84) Benannte Vertragsstaaten:
DE FR GB IT NL

(71) Anmelder: **Siemens Aktiengesellschaft**
**Wittelsbacherplatz 2**
**D-8000 München 2(DE)**

(72) Erfinder: **Bertagnolli, Emmerich, Dr.**
**Nordendstrasse 5**
**D-8000 München 40(DE)**

(54) Herstellverfahren für die aktive Basis eines Bipolartransistors.

(57) Zur Herstellung einer aktiven Basis (20) wird auf einem Halbleitersubstrat (11) durch Aufbringen und Strukturieren einer Reflexionsschicht (19) aus z. B. Aluminium eine Reflexionsmaske erzeugt, die den Bereich für die aktive Basis (20) definiert. In einer Dotierstoff enthaltenden Atmosphäre wird im Bereich der freiliegenden Oberfläche das Halbleitersubstrat (11) mit Hilfe von Laserstrahlung bis zur gewünschten Tiefe der aktiven Basis (20) aufgeschmolzen, so daß nach dem Abschalten der Laserstrahlung die aktive Basis (20) durch Rekristallisation unter Einbau von Dotierstoffatomen entsteht. Die Reflexionsmaske (19) schützt während der Laserbestrahlung den darunter liegenden Bereich vor Laser-induzierten Veränderungen. Das Verfahren ist insbesondere geeignet zur Herstellung einer flachen aktiven Basis und zur selbstjustierten Herstellung einer flachen aktiven Basis in einem Doppelpolysiliziumprozeß, wobei die Reflexionsmaske (19) auf dem die aktive Basis (20) umgebenden Basisanschluß (17) angeordnet wird.

FIG 3

hv

EP 0 399 286 A1

Die Erfindung betrifft ein Herstellverfahren für die aktive Basis eines Bipolartransistors.

Hochgeschwindigkeitsbipolartransistoren weisen eine hohe intrinsische Geschwindigkeit, eine gute Treiberfähigkeit und ausgezeichnete Analog-Eigenschaften auf. Daher besteht weiterhin ein Bedarf an Bipolartransistoren, obwohl diese gegenüber MOS-Transistoren den Nachteil aufweisen, daß sie in komplizierteren Verfahren herzustellen sind.

In der Entwicklung wird eine weitere Erhöhung der Schaltgeschwindigkeit bei gleichzeitiger Reduzierung der parasitären Elemente angestrebt. Die Reduzierung der parasitären Elemente entspricht einer Reduzierung der Verlustleistung. Selbstverständlich sollen die übrigen günstigen Eigenschaften bei der Entwicklung erhalten bleiben.

Als Basisweite $w_B$ wird der Abstand zwischen dem pn-Übergang an der Grenzfläche Emitter-Basis und dem pn-Übergang an der Grenzfläche Basis-Kollektor bezeichnet. Da die Schaltgeschwindigkeit mit der Basisweite korreliert ist, erfordert eine Erhöhung der Schaltgeschwindigkeit die kontrollierte Herstellung von Transistoren mit geringerer Basisweite.

Bipolare Höchstgeschwindigkeitstransistoren, wie sie z. B. in der europäischen Patentanmeldung 0226890 und in der europäischen Patentanmeldung 0239825 beschrieben sind, weisen Basisweiten $W_B$ und Emitterweiten $X_{jE}$ (das ist der Abstand von der Substratoberfläche zu dem pn-Übergang Emitter-Basis) von jeweils 150 bis 250 nm auf. Dabei wird der Emitter durch Ausdiffusion von z. B. Arsen aus dem Polysiliziumanschluß erzeugt. Die Basis wird entweder durch eine Niederenergieimplantation von z. B. Bor oder durch Doppeldiffusion aus der identischen Quelle wie der Emitter gebildet.

Als elektrisches Maß für die Schaltgeschwindigkeit dient die sog. Transitfrequenz. Das ist jene Frequenz, bei der die Stromverstärkung auf den Wert 1 abgesunken ist. Mit den bekannten Bipolartransistoren, die eine implantierte Basis aufweisen, werden Transitfrequenzen bis zu 27 GHz erreicht, wobei jedoch die Kontrollierbarkeit und damit die Möglichkeit einer wirtschaftlichen Fertigung sehr eingeschränkt ist. Für den Einsatz der Bipolartransistoren in Höchstgeschwindigkeit-Schaltkreisen werden Transistoren benötigt, die Transitfrequenzen bis etwa 50 GHz aufweisen. Eine solche Erhöhung der Schaltgeschwindigkeit erfordert Prozesse, mit denen die kontrolierbare Herstellung von Basisweiten kleiner 100 nm möglich ist.

Mit Hilfe von Implantation ist eine kontrollierbare Herstellung von Basisweiten in diesem Bereich nicht möglich, da bei der dabei benötigten niederenergetischen Implantation (Energie der Ionen kleiner als 10 keV) der Channelingeffekt zu ungünstig verschmierten Profilformen führt. Bei der Doppeldiffusionstechnik wird in diesem Basisweiten-Bereich das Linkproblem aufgeworfen. (S. hierzu A. E. Michel et al., Appl. Phys. Lett., 44 (1984) 404, R. G. Wilson, J. Appl. Phys., 54 (1984) 6879, M. Ugajin, 19$^{th}$SSDM Tokyo (1987) 339).

Der Erfindung liegt die Aufgabe zugrunde, ein Herstellverfahren für die aktive Basis eines Bipolartransistors anzugeben, bei dem gut kontrollierbar eine einstellbare Eindringtiefe der Dotierstoffatome für die aktive Basis unter 100 nm, insbesondere zwischen 10 und 100 nm, erzielt wird und daß darüberhinaus kompatibel mit Selbstjustierungsverfahren zur Bipolartransistorherstellung ist.

Die Aufgabe wird erfindungsgemäß durch ein Herstellverfahren für die aktive Basis eines Bipolartransistors gelöst mit folgenden Schritten:

a) auf einem Halbleitersubstrat wird durch Aufbringen und Strukturieren einer Reflexionsschicht eine Reflexionsmaske erzeugt, die den Bereich für die aktive Basis definiert,

b) in einer Dotierstoff enthaltenden Atmosphäre wird im Bereich der freiliegenden Oberfläche das Halbleitersubstrat mit Hilfe von Laserstrahlung bis zu der Eindringtiefe der Dotierstoffatome für die aktive Basis aufgeschmolzen, so daß nach dem Abschalten der Laserstrahlung die aktive Basis durch Rekristallisation unter Einbau von Dotierstoffatomen entsteht,

c) die Reflexionsschicht ist so gewählt, daß sie die Laserstrahlung in einem solchen Maß reflektiert, daß der unter der Reflexionsmaske liegende Bereich durch die Wärme nicht verändert wird.

Die Erfindung macht sich dabei die aus der Flüssigphasenepitaxie bekannte Erkenntnis zu Nutze, daß durch Aufschmelzen eines Bereichs eines Halbleitersubstrats mit Hilfe von Laserstrahlung in einer Dotiergasatmosphäre und anschließende Rekristallisation unter Einschluß von Dotierstoffatomen ein dotiertes Gebiet mit einstellbarer, gut definierter Tiefe entsteht. Dieses Verfahren ist insbesondere für Siliziumsubstrate anwendbar. Mit der Reflexionsmaske, die z. B. aus Aluminium besteht, werden die Bereiche definiert, in denen dotierte Gebiete, hier die aktive Basis, entstehen sollen. Die Reflexionsmaske schützt die damit bedeckten Bereiche des Substrats vor Veränderungen infolge von Wärme.

Auf Siliziumsubstraten ist es besonders vorteilhaft, eine Reflexionsschicht aus Aluminium zu verwenden, da Aluminium Licht in dem Wellenlängenbereich, in dem es von Silizium absorbiert wird, zu über 99 % reflektiert.

In dem Verfahren sind alle Lasertypen geeignet, die zur Materialbehandlung einsetzbar sind, z. B. $CO_2$-Laser, Argon-Laser, Excimerlaser.

Der Laserstrahl wird gepulst. Der Laserstrahl wird mindestens soweit aufgeweitet, daß der vorgesehene Bereich für die aktive Basis vollständig abgedeckt wird. Für eine sinnvolle Nutzung des erfindungsgemäßen Verfahrens ist es vorteilhaft, den Laserstrahl soweit aufzuweiten, daß die Fläche einer gesamten Halbleiterscheibe abgedeckt wird.

Es liegt im Rahmen der Erfindung, als Dotiergas Boran zu verwenden, um eine Bor-dotierte aktive Basis herzustellen. Es wird eine Dotierstoffkonzentration von z. B. $3 \times 10^{18}$ cm$^{-2}$ in einem 50 nm tiefen Bereich erzielt.

Das erfindungsgemäße Verfahren ist insbesondere geeignet zur Herstellung einer flachen aktiven Basis und zur selbstjustierten Herstellung einer flachen aktiven Basis in einem Doppelpolysiliziumprozeß, wobei die Reflexionsmaske auf dem die aktive Basis umgebenden Basisanschluß angeordnet wird.

Das erfindungsgemäße Herstellverfahren für die aktive Basis eines Bipolartransistors ist kompatibel mit den bekannten selbstjustierten Herstellverfahren für Bipolartransistoren. In dem Doppelpolysiliziumprozeß, der z. B. aus dem Aufsatz von A. W. Wieder in Siemens Forschungs- und Entwicklungsberichte, Bd. 13, 1984, Nr. 5 auf den Seiten 246 - 252 bekannt ist, werden die aktive Basis und der Emitter durch Implantation bzw. Diffusion selbstjustiert zum Basisanschlußbereich hergestellt, wobei für die Implantation bzw. Diffusion der Basisanschluß aus dotiertem Polysilizium, aus dem der Basisanschlußbereich durch Ausdiffusion erzeugt wird und der die aktive Basis ringförmig umgibt, als Maske verwendet wird. Bei Verwendung des erfindungsgemäßen Herstellverfahrens zur Herstellung der aktiven Basis in einem Doppelpolysiliziumprozeß wird die Reflexionsmaske auf dem Basisanschluß aus dotiertem Polysilizium erzeugt, wobei zwischen der Reflexionsmaske und dem Basisanschluß eine Oxidschicht vorgesehen ist. Die Reflexionsmaske, die Oxidschicht und der Basisanschluß weisen gemeinsame, senkrecht zur Substratoberfläche ausgerichtete Flanken auf, die den Bereich definieren, in dem die aktive Basis entstehen soll. Bei dem Bestrahlen der frei liegenden Substratfläche mit dem Laser unter Dotierstoffatmosphäre schützt die Reflexionsmaske den darunterliegenden Basisanschluß. Die freiliegende Substratoberfläche wird von der Laserstrahlung aufgeschmolzen bis in die gewünschte Eindringtiefe der Dotierstoffe, wobei nach dem Abschalten der Laserstrahlung die aktive Basis durch Rekristallisation unter Einbau der Dotierstoffatome entsteht. Nach dem Entfernen der Reflexionsmaske, z. B. durch Naßätzung, folgen die bekannten Prozeßschritte. Beim Entfernen der Reflexionsmaske dient die Oxidschicht zum Schutz des Basisanschlusses und zum Ätzstopp.

In Varianten des Doppelpolysiliziumprozesses, in denen der Basisanschluß aus einem Polysiliziumspacer, aus einem Polyzid (das ist eine aus Polysilizium und Silizid bestehende Doppelschicht), einem Silizid oder einem hochschmelzenden Metall wie z. B. Wolfram gebildet wird, ist das erfindungsgemäße Verfahren ebenfalls einsetzbar.

Die erfindungsgemäße Herstellung der aktiven Basis ist ebenfalls kompatibel mit dem Herstellungsverfahren, das in der europäischen Patentanmeldung EP 0239825 beschrieben ist. Bei diesem Verfahren wird zunächst die aktive Basis im Substrat hergestellt. Anschließend wird an einer oberhalb der aktiven Basis angeordneten Oxidkante durch konforme Abscheidung von leitfähigem Material und Rückätzen dieser Schicht ein Ätzresiduum erzeugt, aus dem der Emitter durch Ausdiffusion entsteht, wobei das Ätzresiduum einen Teil des Emitteranschlußgebietes darstellt.

Das erfindungsgemäße Verfahren ist mit allen Herstellverfahren für Bipolartransistoren kompatibel, bei denen die aktive Basis in einer Siliziumschicht oder einem Siliziumsubstrat durch Implantation oder Ausdiffusion unter Verwendung einer Maske hergestellt wird. Der Begriff Maske ist hier weit zu verstehen, es kann sich sowohl um eine fremdjustierte Photolackmaske als auch um eine selbstjustierte Maske z. B. den Basisanschluß als Polysilizium wie im Doppelpolysiliziumprozeß, handeln.

Weitere Ausgestaltungen der Erfindung gehen aus den übrigen Ansprüchen hervor.

Im folgenden wird die Erfindung anhand der Ausführungsbeispiele und der Figuren näher erläutert.

Fig. 1 bis Fig. 6 zeigt Verfahrensschritte zur Herstellung eines Bipolartransistors, wobei die Reflexionsmaske oberhalb der Polysiliziumschicht für den Basisanschluß angeordnet ist.

Fig. 7 bis Fig. 11 zeigt Verfahrensschritte zur Herstellung eines Bipolartransistors in einem Doppelpolysiliziumprozeß, wobei die Reflexionsmaske oberhalb des mit einer Oxidschicht und mit Oxidspacern versehenen Basisanschlusses angeordnet ist.

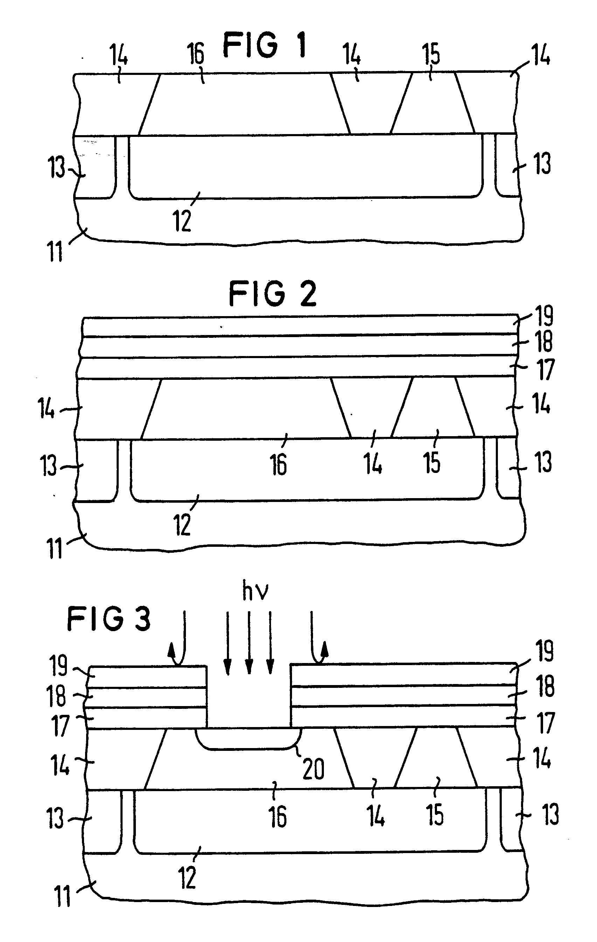

Die in Fig. 1 dargestellte Struktur wird, wie z. B. aus der europäischen Patentanmeldung 0226890 bekannt ist, dadurch hergestellt, daß in einem z. B. p-dotierten Siliziumsubstrat 11 durch maskierte Ionenimplantation von z. B. Antimom oder Arsen ein vergrabener Kollektorbereich 12 gebildet wird. Es folgt die ganzflächige Abscheidung einer z. B. n=dotierten Epitaxieschicht in einer Schichtdicke von z. B. 0,5 bis 2 μm. Durch Ionenimplantation oder Diffusion mit z. B. Bor werden Channel-Stopper-Bereiche 13 erzeugt, die für eine sichere Isolation zwischen benachbarten Kollektorgebieten sorgen und damit zur Vermeidung eines parasitären Dickoxidtransistors beitragen. Für die Trennung der aktiven Transistorbereiche im Siliziumsubstrat 11 werden durch lokale Oxidation unter Verwendung von zuvor erzeugten Siliziumnitridstrukturen als Oxidationsmaske Feldoxide 14 erzeugt. Zur Trennung der aktiven Bereiche kann auch eine Isolation durch Gräben (sog. trenches) eingesetzt werden.

Nach Entfernung der Nitrid/Oxid Maskierung und einer Photolacktechnik wird ein Kollektoranschlußbereich 15 durch Implantation oder Diffusion von z. B. Phosphor hergestellt. In einem Hochtemperaturschritt wird der Kollektoranschlußbereich 15 bis zum vergrabenen Kollektorbereich 12 eingetrieben. Durch die Feldoxide 14 wird die Epitaxieschicht aufgeteilt in den Kollektoranschlußbereich 15 und eine sog. Basis/Emitter-Epitaxieinsel 16, die zur Aufnahme des aktiven Transistors bestimmt ist.

Auf die Oberfläche der Feldoxide 14, des Kollektoranschlußbereichs 15 und der Basis/Emitter-Epitaxieinsel 16 wird ganzflächig eine erste Polysiliziumschicht 17 aufgebracht (s. Fig. 2). Die erste Polysiliziumschicht 17, die eine Dicke von z. B. 100 nm aufweist, wird durch Implantation oder Diffusion mit Bor dotiert mit einer Dosis von z. B. $4 \times 10^{15}$ $cm^{-2}$ und einer Energie von z. B. 25 kev. Alternative Herstellmöglichkeiten für die erste Polysiliziumschicht 17 bestehen in der Abscheidung von In-situ dotiertem Polysilizium oder einer amorphen, nachträglich kristallisierten Schicht. Auf der ersten Polysiliziumschicht 17 wird eine erste Isolationsschicht 18 abgeschieden. Die erste Isolationsschicht 18 besteht z. B. aus Oxid und wird in einer Dicke von z. B. 100 nm durch Zersetzen von Si $(OC_2H_5)_4$, sog. TEOS, hergestellt. Auf die erste Isolationsschicht 18 wird eine Reflexionsschicht 19 abgeschieden. Die Reflexionsschicht 19 besteht z. B. aus Aluminium und weist eine Dicke von z. B. 500 nm auf.

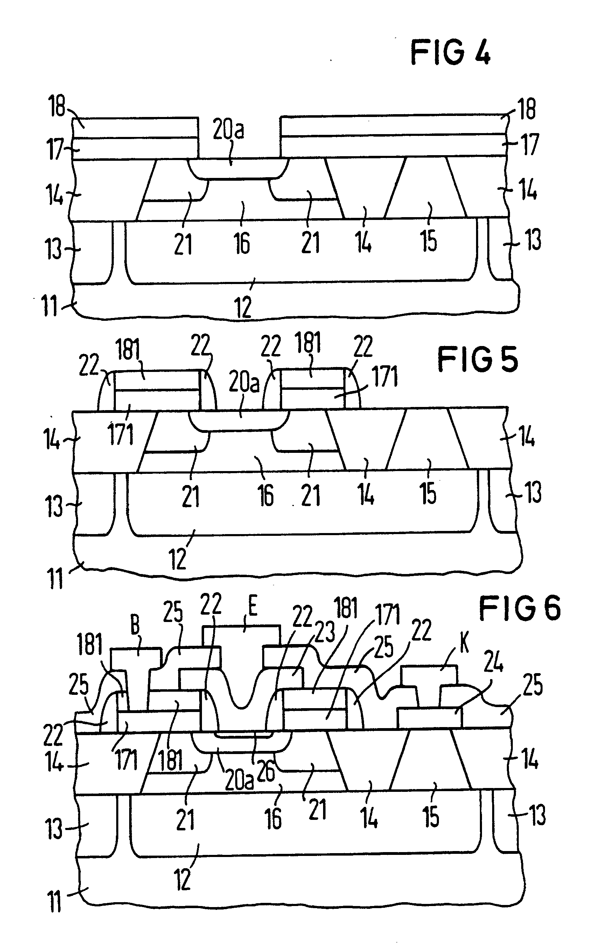

Mit einer Phototechnik wird der Bereich des aktiven Transistors definiert (nicht dargestellt). Die Reflexionsschicht 19, die erste Isolationsschicht 18 und die erste Polysiliziumschicht 17 werden entsprechend der Photomaske geätzt, so daß die Oberfläche der Basis/Emitter-Epitaxieinsel 16 freigelegt wird. Die strukturierte Reflexionsschicht 19 bildet eine Reflexionsmaske. Die freigelegte Oberfläche wird in einer Dotierstoff enthaltenden Atmosphäre, z. B. in einer mit Boran gefüllten Kammer, mit einem Laser bestrahlt (s. Fig. 3). Die Laserstrahlung wird gepulst. Die Laserleistung wird so gewählt, daß das freiliegende Silizium bis zur gewünschten Tiefe des Basis-Kollektor-pn-Übergangs aufgeschmolzen wird. In der dabei entstehenden Schmelzzone 20 verteilt sich der Dotierstoff dabei mit der gewünschten Konzentration von z. B. $3 \times 10^{18}$ $cm^{-2}$. Die Reflexionsschicht 19 stellt dabei sicher, daß die Struktur außerhalb der von der Maskierschicht freiliegenden Oberfläche nur eine minimale Leistung absorbieren muß und daher nur auf wenige 100 °C (z. B. 400 °C) erwärmt wird. Dadurch ist gewährleistet, daß außerhalb des gewünschten Bereichs keine Veränderungen oder Schädigungen der Struktur auftreten. Nach dem Abschalten des Lasers rekristallisiert die Schmelzzone 20 und bildet ein $p^+$-dotiertes Gebiet 20a (s. Fig. 4).

Die bei der Laserbestrahlung auftretende Wärme kann dazu ausgenutzt werden, in der Basis/Emitter-Epitaxieinsel 16 einen Basisanschlußbereich 21 durch Ausdiffusion aus der ersten Polysiliziumschicht 17 zu erzeugen. Der Basisanschlußbereich 21 umgibt das $p^+$-dotierte Gebiet 20a ringförmig. Eine alternative Herstellungsart für den Basisanschlußbereich 21 besteht darin, vor der Laserbestrahlung einen Temperschritt auszuführen, um die Ausdiffusion der Dotierstoffe aus der ersten Polysiliziumschicht 17 zur Bildung des Basisanschlußbereichs 21 zu bewirken. In diesem Fall können der Temperschritt und der Schmelz- bzw. Kristallisationsschnitt unabhängig voneinander optimiert werden.

Nach der Erzeugung des $p^+$-dotierten Gebietes 20a sowie des dieses ringförmig umgebenden Anschlußbereichs 21 wird die Reflexionsmaske z. B. durch Nassätzung entfernt (s. Fig. 4). Dabei wirkt die erste Isolationsschicht 18 als Ätzstopp.

Nach einer Phototechnik werden die erste Isolationsschicht 18 und die erste Polysiliziumschicht 17 so geätzt, daß ein Basisanschluß 171 aus der ersten Polysiliziumschicht 17 und eine erste Isolationsstruktur 181 aus der ersten Isolationsschicht 18 entsteht (s. Fig. 5). Nach Abscheiden einer weiteren Isolationsschicht aus z. B. Oxid und einem Rückätzschritt werden Flankenisolationen 22, sog. Oxid-Spacer, erzeugt.

Nach einer Grenzflächenbehandlung wird ganzflächig eine zweite Polysiliziumschicht abgeschieden. Die zweite Polysiliziumschicht wird so dotiert, daß sie vom entgegengesetzten Leitfähigkeitstyp wie die erste Polysiliziumschicht 17 ist. Die Dotierung erfolgt z. B. mit Arsen. Sie erfolgt entweder bei der Abscheidung oder im Anschluß an die Abscheidung der zweiten Polysiliziumschicht.

Nach einer weiteren Phototechnik und einer entsprechenden Ätzung werden aus der zweiten Polysiliziumschicht ein Emitteranschluß 23 und ein Kollektoranschluß 24 erzeugt (s. Fig. 6). Im folgenden wird die Struktur ganzflächig mit einer zweiten Isolationsschicht 25 bedeckt. Die zweite Isolationsschicht 25 besteht z. B. aus Oxid.

Es folgt ein Temperaturschritt zur Austreibung und Aktivierung des Emitters 26. Der unter dem Emitter 26 angeordnete Teil des $p^+$-dotierten Gebietes 20 a bildet die aktive Basis. Zur Aktivierung ist z. B. ein Ofenprozß geeignet in einem Temperaturbereich zwischen 800 und 1000 °C, der einige Minuten dauert. Ebenfalls geeignet ist ein schnelles thermisches Ausheilverfahren, sog. Rapid Thermal Annealing, in einem Temperaturbereich zwischen 800 und 1100 °C, das einige Sekunden dauert. Eine dritte Möglichkeit steht im Ausheilen mit Laser, sog. Laserannealing, z. B. mit einem gepulsten Excimerlaser, das den Vorteil hat, daß damit eine präzise Einstellung von extrem flachen Emittern möglich ist.

Nach der phototechnischen Definition und anschließenden Ätzung der Kontaktlöcher zum Emitteranschluß 23, dem Kollektoranschluß 24 und dem Basisanschluß 171 erfolgt die Metallisierung der Kontakte B, E und K mit z. B. PtSi/TiW/AlSiTi.

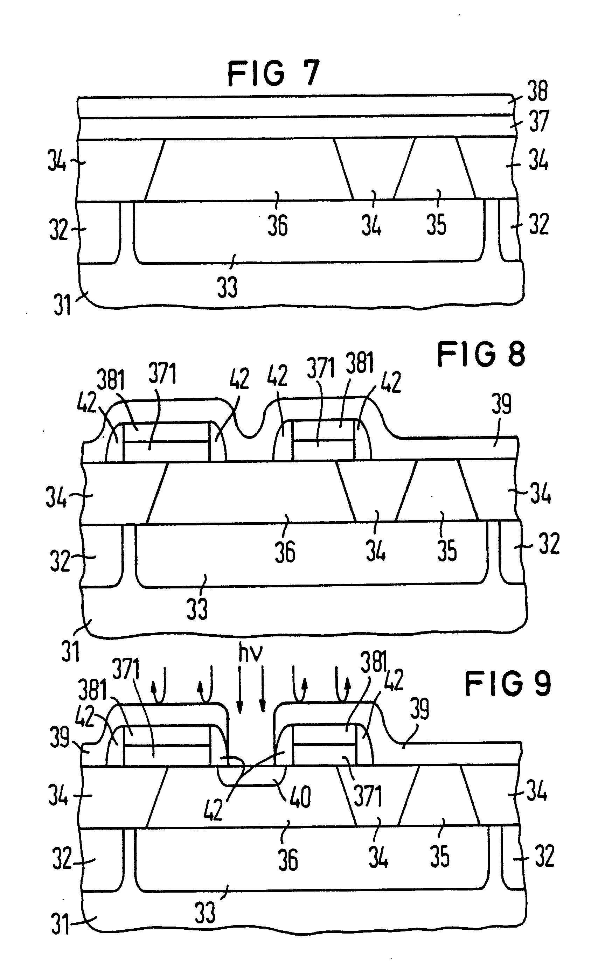

Anhand von Fig. 7 bis Fig. 11 wird im folgenden ein weiteres Ausführungsbeispiel beschrieben.

In Fig. 7 ist eine Struktur dargestellt, die analog der in Fig. 1 und Fig. 2 dargestellten Struktur hergestellt wird. In einem Siliziumsubstrat 31 ist ein vergrabener Kollektorbereich 32 angeordnet. In dem Siliziumsubstrat 31 sind ferner Channel-Stopper-Bereiche 33 angeordnet, die für eine Isolation zwischen benachbarten Kollektorgebieten sorgen. Auf dem Siliziumsubstrat 31 ist ferner eine Epitaxieschicht angeordnet, die durch Feldoxide 34 in einen Kollektoranschlußbereich 35 und in eine Basis/Emitter-Epitaxieinsel 36 unterteilt ist. Darauf wird eine z. B. p-dotierte erste Polysiliziumschicht 37 und darauf eine erste Isolationsschicht 38 erzeugt (s. Fig. 7).

Nach einer Phototechnik werden die erste Isolationsschicht 38 und die erste Polysiliziumschicht 37 so geätzt, daß ein Basisanschluß 371 und eine diesen bedeckenden erste Isolationsstruktur 381 entstehen (s.Fig. 8). Nach dem Abscheiden und anschließendem Rückätzen einer weiteren Isolationsschicht (nicht dargestellt) werden Flankenisolationen 42, die die Flanken des Basisanschlusses 371 bedecken, erzeugt. Die Oberfläche dieser Struktur wird mit der erfindungsgemäßen Reflexionsschicht 39 bedeckt. Die Reflexionsschicht 39 besteht z. B. aus Aluminium.

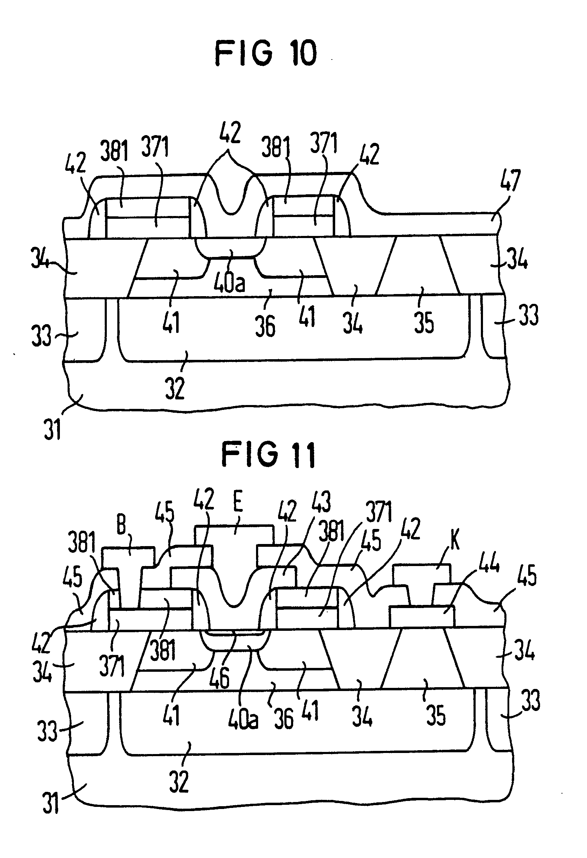

Nach einer Phototechnik wird durch Ätzen die Reflexionsschicht 39 so strukturiert, daß ein Teil der Oberfläche der Basis/Emitter-Epitaxieinsel 36 freigelegt wird, und zwar derjenige Teil, in dem der aktive Transistorbereich vorgesehen ist (s. Fig. 9). Die strukturierte Reflexionsschicht 39 bildet eine Reflexionsmaske. In einer dotierstoffenthaltenden Atmosphäre, z. B. in einer Kammer mit Boran, erfolgt der erfindungswesentliche Schritt, das Aufschmelzen der freiliegenden Oberfläche mit Hilfe von Laserstrahlung. Dabei entsteht eine Schmelzzone 40, in der sich der Dotierstoff gleichmäßig verteilt. Es wird ein Laser verwendet, dessen Leistung und Pulsfrequenz so gewählt werden, daß die Schmelzzone 40 eine Tiefe hat, die der gewünschten Tiefe des Basis-Kollektor-pn-Übergangs entspricht. Die Reflexionsschicht 39 stellt sicher, daß die Struktur außerhalb der frei liegenden Oberfläche durch die Wärme nicht verändert wird. Nach dem Abschalten des Lasers rekristallisiert die Schmelzzone 40 unter Einbau der Dotierstoffe zu einem $p^+$-dotierten Gebiet 40a (s. Fig. 10). Durch die Laserwärme oder einen zusätzlichen Temperschritt wird ein Basisanschlußbereich 41 erzeugt, der durch Ausdiffusion aus dem Basisanschluß 371 entsteht und der selbstjustiert ringförmig um das $p^+$-dotierte Gebiet 40a angeordnet ist.

Nach Entfernung der Reflexionsschicht 39, z. B. durch Nass ätzen, wird ganzflächig eine zweite Polysiliziumschicht 47 erzeugt. Die zweite Polysiliziumschicht 47 ist vom entgegengesetzten Leitfähigkeitstyp wie die erste Polysiliziumschicht 37 dotiert.

Durch eine Phototechnik und eine anschließende Ätzung der zweiten Polysiliziumschicht 47 werden ein Emitteranschluß 43 und ein Kollektoranschluß 44 erzeugt (s. Fig. 11). Die Struktur wird ganzflächig mit einer zweiten Isolationsschicht 45 versehen. In einem nachfolgenden Temperaturschritt wird der Emitter 46 durch Ausdiffusion aus dem Emitteranschluß 43 erzeugt. Der unter dem Emitter 46 angeordnete Teil des $p^+$-dotierten Gebietes 40a bildet die aktive Basis. Zur Ausdiffusion sind die Temperaturschritte, die im Zusammenhang mit Fig. 6 erläutert wurden, geeignet.

Nach dem Öffnen von Kontaktlöchern auf dem Basisanschluß 371, dem Emitteranschluß 43 und dem Kollektoranschluß 44 werden der Emitterkontakt E, der Basiskontakt B und der Kollektorkontakt K durch Metallisierungen mit z. B. PtSi/TiW/AlSiTi erzeugt.

## Ansprüche

1. Herstellverfahren für die aktive Basis eines Bipolartransistors mit folgenden Schritten:

a) auf einem Halbleitersubstrat (11, 31) wird durch Aufbringen und Strukturieren einer Reflexionsschicht (19, 39) eine Reflexionsmaske erzeugt, die den Bereich für die aktive Basis (20a, 40a) definiert,

b) in einer Dotierstoff enthaltenden Atmosphäre wird im Bereich der freiliegenden Oberfläche das Halbleitersubstrat (11, 31) mit Hilfe von Laserstrahlung bis zur Tiefe der aktiven Basis (20a, 40a) aufgeschmolzen, so daß nach dem Abschalten der Laserstrahlung die aktive Basis (20a, 40a) durch Rekristallisation unter Einbau von Dotierstoffatomen entsteht,

c) die Reflexionsschicht (19, 39) ist so gewählt, daß sie die Laserstrahlung in einem solchen Maß reflektiert, daß der unter der Reflexionsmaske liegende Bereich durch die Wärme nicht verändert wird.

2. Herstellverfahren nach Anspruch 1, **dadurch gekennzeichnet,** daß ein Halbleitersubstrat (11, 31) aus Silizium verwendet wird.

3. Herstellverfahren nach Anspruch 1 oder 2, **dadurch gekennzeichnet,** daß eine Reflexionsschicht (19, 39) aus Aluminium in einem Dickenbereich zwischen 50 nm und 1200 nm verwendet wird.

4. Herstellverfahren nach einem der Ansprüche 1 bis 3, **dadurch gekennzeichnet,** daß die Dotierstoff enthaltende Atmosphäre in einer mit Boran gefüllten Reaktionskammer realisiert ist.

5. Herstellverfahren nach einem der Ansprüche 1 bis 4, **dadurch gekennzeichnet,** daß die aktive Basis selbstjustiert zu einem sie umgebenden Basisanschluß (171) dadurch hergestellt wird,

    a) daß der Basisanschluß (171) von einer Isolationsstruktur (181) bedeckt ist,

    b) daß die Reflexionsmaske auf der Isolationsstruktur (181, 381) erzeugt wird,

    c) daß der Basisanschluß (171), die Isolationsstruktur (181) und die Reflexionsmaske (19) gemeinsame, senkrecht zur Substratoberfläche ausgerichtete Flanken aufweisen, die den Bereich für die aktive Basis (20a) definieren.

6. Herstellverfahren nach einem der Ansprüche 1 bis 4, **dadurch gekennzeichnet,** daß die aktive Basis selbstjustiert zu einem sie umgebenden Basisanschluß (371) dadurch hergestellt wird,

    a) daß der Basisanschluß von einer Isolationsstruktur (381) und Flankenisolationen (42) vollständig abgedeckt ist,

    b) daß die Reflexionsmaske (39) auf der Isolationsstruktur (381) und der Flankenisolation (42) angeordnet ist,

    c) daß lediglich im Bereich innerhalb des Basisanschlusses (371) und der Flankenisolationen (42) die Substratoberfläche von der Reflexionsmaske (39) unbedeckt ist.

7. Integrierte Schaltung mit mindestens einem Bipolartransistor, dessen aktive Basis nach einem Verfahren nach einem der Ansprüche 1 bis 6 hergestellt ist.

FIG 1

FIG 2

FIG 3

## FIG 4

## FIG 5

## FIG 6

## FIG 7

38
37
34
34
32
36  34  35
32
33
31

## FIG 8

381  371  42  42  371  381  42
42
39
34
34
32
36  34  35
32
33
31

## FIG 9

hν
371  381 42
381
42  39
39
34
42  40  371  34
32
36  34  35
32
33
31

## FIG 10

## FIG 11

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| P,X | IEEE ELECTRON DEVICE LETTERS Band 10, Nr. 6, Juni 1989, Seiten 260-263, New York, US: K.H. WEINER et al.: "Thin-Base Bipolyr Transistor Fabrication Using Gas Immersion Laser Doping" * Seite 260; Seite 261, linke Spalte; Figur 1 * | 1-4 | H 01 L 21/331 H 01 L 21/268 H 01 L 21/223 H 01 L 21/82 |
| X | PROCEEDINGS OF THE 1988 BIPOLAR CIRCUITS AND TECHNOLOGY MEETING 12.-13. September 1988, Seiten 37-40, Hyatt Regency Hotel, Menneapolis, Minnesota, US; K.H. WEINER et al.: "Emitter and Base Fabrication In Advanced Bipolar Transistors Using Gas Immersion laser Doping" * Seiten 37,38; Figur 2 * | 1,2,4 | |
| Y | idem | 3 | |
| A | idem | 5,7 | RECHERCHIERTE SACHGEBIETE (Int. Cl.5) |
| Y | EXTENDED ABSTRACTS/ELECTROCHEMICAL SOCIETY Band 87-2, 1987, Seiten 600,601, Princeton, New Jersey, US; P.G. CAREY et al.: "Fabrication and Characterization of Diodes Using the Gas Immersion Laser Doping (GILD) Process in Silicon" * Seite 600, linke Spalte; Figur 1 * | 3 | H 01 L |
| A | EP-A-0 096 155 (IBM) * Seiten 3,4; Figuren 2a-2d * -/- | 5,6 | |

Der vorliegende Recherchenbericht wurde für alle Patentansprüche erstellt

| Recherchenort | Abschlußdatum der Recherche | Prüfer |
|---|---|---|
| BERLIN | 23-07-1990 | KLOPFENSTEIN P R |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

..............................................................................
& : Mitglied der gleichen Patentfamilie, übereinstimmendes Dokument

EPO FORM 1503 03.82 (P0403)

Europäisches
Patentamt

# EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | US-A-4 492 008 (N.G. ANANTHA et al.) * Spalte 5, Zeile 11 - Spalte 6, Zeile 33; Figuren 5-7 * --- | 6,7 | |
| A | IBM TECHNICAL DISCLOSURE BULLETIN Band 25, Nr. 9, Februar 1983, Seiten 4763,4764, New York, US; H.R. POTTS: "Patterned Laser Heating" * ganzes Dokument * ----- | 1,3,5 | |

RECHERCHIERTE
SACHGEBIETE (Int. Cl.5)

Der vorliegende Recherchenbericht wurde für alle Patentansprüche erstellt

| Recherchenort | Abschlußdatum der Recherche | Prüfer |
|---|---|---|
| BERLIN | 23-07-1990 | KLOPFENSTEIN P R |

EPO FORM 1503 03.82 (P0403)